# EUROPEAN PATENT APPLICATION

(11) **EP 4 075 670 A1**
(43) Date of publication of application: **19.10.2022**
(21) Application number: 20900376.3
(22) Date of filing: 27.10.2020
(51) Int. Cl.: H03H 17/00

(54) **FIR FILTER-BASED FILTERING METHOD, APPARATUS, AND DEVICE, AND STORAGE MEDIUM**

(30) Priority: 13.12.2019 CN 201911283089
(71) Applicant: Sanechips Technology Co., Ltd., Shenzhen, Guangdong 518055 (CN)
(72) Inventor: YAN, Dichao, Shenzhen, Guangdong 518057 (CN)
(74) Representative: Aipex B.V.
(86) International application number: PCT/CN2020/123935
(87) International publication number: WO 2021/114907

(57) **Abstract**

An FIR filter-based filtering method and apparatus, a system, and a storage medium are provided. The FIR filter-based filtering method includes: acquiring (S11) a preset filtering order and a preset down-sampling multiple; selecting (S12), according to the preset down-sampling multiple, a corresponding number of filter multiplexing units, and using each of the selected filter multiplexing units as a used filter multiplexing unit, wherein the FIR filter includes multiple filter multiplexing units; configuring (S13), according to the preset filtering order, a filtering order for each used filter multiplexing unit; filtering (S14), according to the preset down-sampling multiple, input data allocated to each used filter multiplexing unit through the each used filter multiplexing unit configured with the filtering order, to obtain unit filtered data outputted by the each used filter multiplexing unit; and merging (S15) the unit filtered data respectively outputted by the corresponding number of used filter multiplexing units and outputting merged unit filtered data.

## Description

This application claims the priority to Chinese Patent Application No. 201911283089.6 filed with the China National Intellectual Property Administration (CNIPA) on December 13, 2019, the content of which is incorporated herein in its entirety.

### TECHNICAL FIELD

The present application relates to the technical field of digital signal processing, for example, to a finite impulse response (FIR) filter-based filtering method, an FIR filter-based filtering apparatus, a system and a storage medium.

### BACKGROUND

At a digital receiving front end, in a signal processing process, the high-speed analog-to-digital conversion output contains both useful signals and interference signals. By a digital signal processing system, the useful signals are separated and extracted, and are shifted to a baseband, and at the baseband, out-of-band interferences are filtered by a digital filter.

When it is required to support multiple-scene filtering processing, multiple single-mode filters are required to perform corresponding filtering operations respectively, which consumes more resources and requires a large amount of code for logic implementation.

### SUMMARY

An FIR filter-based filtering method, an FIR filter-based filtering apparatus, a system and a storage medium are provided according to embodiments of the present application.

An FIR filter-based filtering method is provided, the filtering method includes:
acquiring a preset filtering order and a preset down-sampling multiple;
selecting, according to the preset down-sampling multiple, a corresponding number of filter multiplexing units, and using each of the selected filter multiplexing units as a used filter multiplexing unit, where the FIR filter includes a plurality of filter multiplexing units;
configuring, according to the preset filtering order, a filtering order for each used filter multiplexing unit;
filtering, according to the preset down-sampling multiple, input data allocated to each used filter multiplexing unit through the each used filter multiplexing unit configured with the filtering order, to obtain unit filtered data outputted by the each used filter multiplexing unit; and
merging the unit filtered data respectively outputted by the corresponding number of used filter multiplexing units and outputting merged unit filtered data.

An FIR filter-based filtering apparatus is further provided, and the filtering apparatus includes: a filtering parameter acquisition module, a multiplexing unit selection module, a unit order configuration module, a unit data output module and a data merging module.

The filtering parameter acquisition module is configured to acquire a preset filtering order and a preset down-sampling multiple.

The multiplexing unit selection module is configured to select, according to the preset down-sampling multiple, a corresponding number of filter multiplexing units, and use each of the selected filter multiplexing units as a used filter multiplexing unit, wherein the FIR filter comprises multiple filter multiplexing units.

The unit order configuration module is configured to configure, according to the preset filtering order, a filtering order for each used filter multiplexing unit.

The unit data output module is configured to filter, according to the preset down-sampling multiple, input data allocated to each used filter multiplexing unit through the each used filter multiplexing unit configured with the filtering order, to obtain unit filtered data outputted by the each used filter multiplexing unit.

The data merging module is configured to merge the unit filtered data respectively outputted by the corresponding number of used filter multiplexing units and output merged unit filtered data.

A device is further provided, and the device includes a processor and a memory.

The processor is configured to execute a program stored in the memory, to implement the above-described FIR filter-based filtering method.

A storage medium is further provided, and the storage medium stores a computer program, and when the computer program is executed by a processor, the above-described FIR filter-based filtering method is implemented.

### BRIEF DESCRIPTION OF DRAWINGS

Fig. 1 is a schematic structural diagram of an FIR filter;
Fig. 2 is a flowchart of an FIR filter-based filtering method according to an embodiment;
Fig. 3 is a schematic structural diagram of an FIR filter according to an embodiment;
Fig. 4 is another flowchart of an FIR filter-based filtering method according to an embodiment; and
FIG. 5 is a schematic structural diagram of an FIR filter-based filtering apparatus according to an embodiment.

### DETAILED DESCRIPTION

The embodiments of the present application are described hereinafter with reference to the accompany drawings.

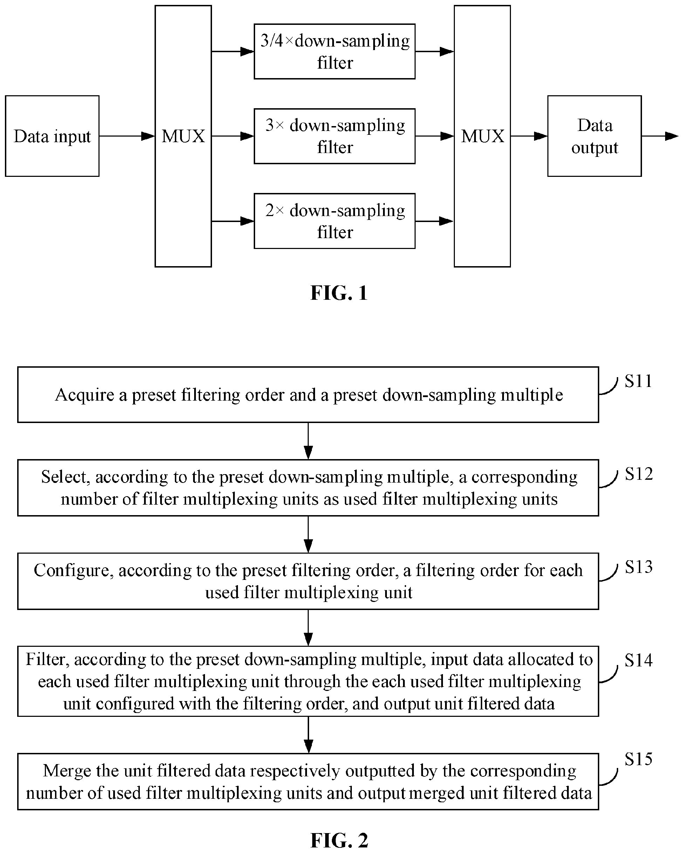

In RF circuits with high sampling rates, it is generally required to use multiple filters to perform down-sampling on data and to perform anti-aliasing filtering on the data. Since a single chip is required to support a variety of application scenes such as the 2th generation mobile communication system (2G), 3G, 4G and 5G, it is required to deploy down-sampling filters on the links in parallel to deal with the variety of application scenes, therefore a large number of filters are required. As shown in Figure 1, multiple single-mode filters are deployed in parallel, and input data are allocated to a corresponding single-mode filter through a multiplexer (MUX) to achieve filtering on the input data. In this way, in order to support multiple scenes, multiple single-mode filters are needed to be deployed, resulting in more resource consumption and more code amount for logic implementation.

FIG. 2 is a flowchart of an FIR filter-based filtering method according to an embodiment. As shown in FIG. 2, the method is applicable to a multi-mode FIR filter on a communication link, and the method includes: operations in S11, S12, S13, S14 and S15.

Operation in S11 includes acquiring a preset filtering order and a preset down-sampling multiple.

Operation in S12 includes selecting, according to the preset down-sampling multiple, a corresponding number of filter multiplexing units as used filter multiplexing units. The FIR filter includes multiple filter multiplexing units.

Operation in S13 includes configuring, according to the preset filtering order, a filtering order for each used filter multiplexing units.

Operation in S14 includes filtering, according to the preset down-sampling multiple, input data allocated each used filter multiplexing unit through the each used filter multiplexing units configured with the filtering order, and outputting unit filtered data.

Operation in S15 includes merging the unit filtered data respectively outputted by the corresponding number of used filter multiplexing units and outputting merged unit filtered data.

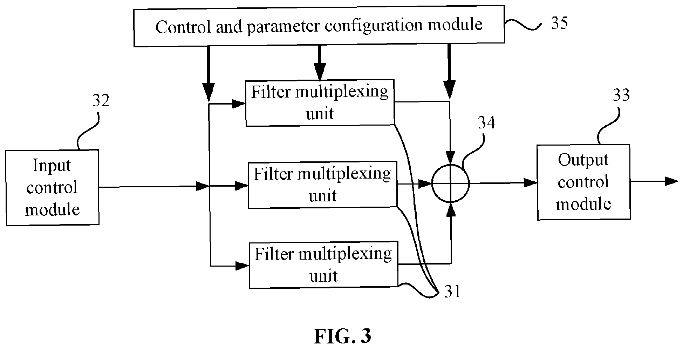

As shown in FIG. 3, in the embodiments of the present application, the FIR filter includes multiple filter multiplexing units 31. In FIG. 3, three filter multiplexing units 31 are illustrated as an example. The FIR filter further includes an input control module 32, an output control module 33, a data merging module 34 and a control and parameter configuration module 35. The filter multiplexing units 31 each can perform functions such as data beating, timing sequence control, and multi-add operation on input data and coefficients. Each of the filter multiplexing units 31 has its own data input control logic to control a phase of data input and timing sequence of data input. The FIR filter can configure a decimation mode of the FIR filter through the control and parameter configuration module 35, so as to configure whether each of the three filter multiplexing units 31 is used, and to configure a filtering order used by each of the filter multiplexing units 31.

The preset filtering order and the preset down-sampling multiple are filtering parameters needed when the FIR filter is required to perform a filtering operation on input data according to a practical scenario. When the FIR filter filters the input data, the FIR filter allocates the input data to at least part of the filter multiplexing units to perform multi-add operation on the input data and filter coefficients of the at least part of the filter multiplexing units. Therefore, it is necessary to select, according to the preset down-sampling multiple, a corresponding number of filter multiplexing units as used filter multiplexing units, and the input data will be evenly allocated to these used filter multiplexing units according to a timing sequence of the data input. When the preset filtering order is acquired, and the number of the used filter multiplexing is determined, each of the used filter multiplexing unit is required to evenly share the preset filtering order to perform filtering operation. When the FIR filter performs filtering, the input data will be evenly allocated to the used filter multiplexing units according to the timing sequence, and after the used filter multiplexing units each performed multi-add operation on the input data and a respective filter coefficient, the unit filtered data is obtained. The unit filtered data outputted by all the used filter multiplexing units is merged to obtain the filtered data finally outputted by the FIR filter. The input data is evenly allocated to the used filter multiplexing units for filtering operation according to the timing sequence of the data input, and after the used filter multiplexing units output their respective unit filtered data, the unit filtered data is also required to be arranged according to the timing sequence of the data input before the filtering operation, to realize the operation of merging the unit filtered data, and the merged unit filtered data is used as the output filtered data of the FIR filter.

In an implementation, operation in S12 includes: selecting a number of filter multiplexing units same as the preset down-sampling multiple as the used filter multiplexing units in a case where the preset down-sampling multiple is an integer.

Operation in S14 includes: performing multi-add operation on the input data and respective preset filtering coefficients by the each used filter multiplexing unit configured with the filtering order to obtain the unit filtered data, wherein the multi-add operation is performed in a number of clock cycles same as the preset down-sampling multiple.

In an example, if the preset down-sampling multiple is 3, three filter multiplexing units may be selected as used filter multiplexing units. Within 3 clock cycles, the three filter multiplexing units are used to perform multi-add operation on the input data to obtain unit filtered data. By merging the unit filtered data outputted by the three used filter multiplexing units, 3 X decimation filtering may be achieved. The filter coefficients of the three used filter multiplexing units are (0, 3, 6, 9, ...), (1, 4, 7, 10, ...) and (2, 5, 8, 11...) respectively, and by selecting orders of the used filter multiplexing units according to the preset filtering order, filtering with the preset filtering order may be achieved. If the preset down-sampling multiple is 2, two filter multiplexing units may be selected as used filter multiplexing units. Within 2 clock cycles, these two filter multiplexing units are used to perform multi-add operation on the input data to obtain unit filtered data. By merging the unit filtered data outputted by the two used filter multiplexing units, the 2 X decimation filtering may be achieved. In this case, for the 2 X decimation filtering, there is a unused filter multiplexing unit, and when to perform 2 X decimation filtering, the unused filter multiplexing unit may be shielded by hardware, to allow make the output of the unused filter multiplexing unit to be all 0, then the output results of the two used filter multiplexing units are merged to be the result of the 2 X down-sampling filtering.

In an implementation, operation in S12 includes: in a case where the preset down-sampling multiple is a fraction, selecting a number of filter multiplexing units same as a numerator of the preset down-sampling multiple as the used filter multiplexing units.

Operation in S14 includes: performing multi-add operation on the input data and respective preset filtering coefficients by the each used filter multiplexing unit configured with the filtering order to obtain the unit filtered data, wherein the multi-add operation is performed by using a number of clock cycles same as the numerator of the preset down-sampling multiple and within a number of clock cycles same as a denominator of the preset down-sampling multiple.

In an example, if the preset down-sampling multiple is 3/4, three filter multiplexing units may be selected as used filter multiplexing units. Within 4 clock cycles, the three filter multiplexing units are used to perform multi-add operation on the input data in the first 3 clock cycles, and in the fourth clock cycle, only shifting is performed and filtering is not performed, to obtain unit filtered data. By merging the unit filtered data outputted by the three used filter multiplexing units, 3/4 X decimation filtering may be achieved.

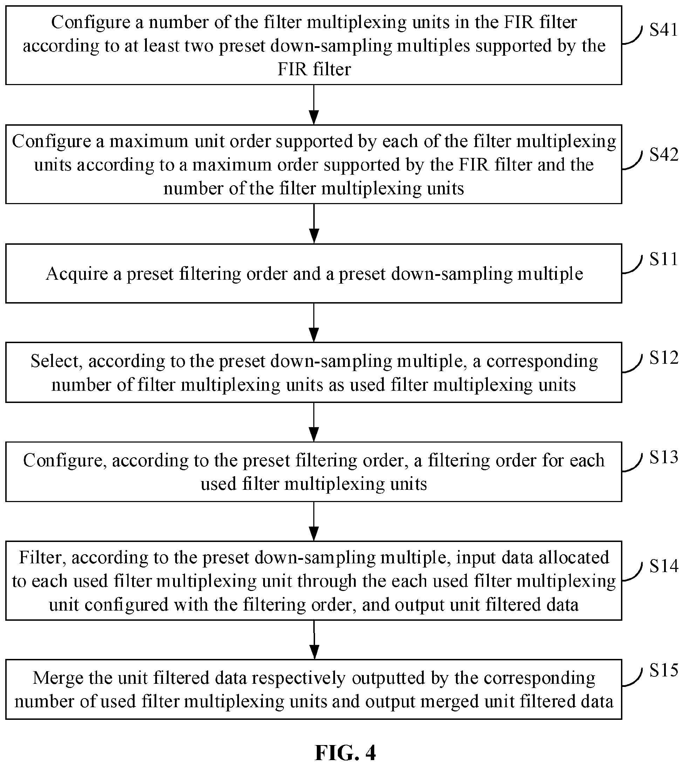

In an implementation, as shown in FIG. 4, before operation in S11, the method further includes: operation in S41 and operation in S42.

Operation in S41 includes configuring a number of the plurality of filter multiplexing units in the FIR filter according to at least two preset down-sampling multiples supported by the FIR filter, where a preset down-sampling multiples is an integer and/or a fraction.

Operation in S42 includes configuring a unit maximum order supported by each of the plurality of filter multiplexing units according to a maximum order supported by the FIR filter and the number of the plurality of filter multiplexing units, where the filter multiplexing units are each configured to have functions for performing data beating, timing sequence control, and multi-add operation on data and coefficients.

In an implementation, operation in S41 includes: in a case where the at least two preset down-sampling multiples supported by the FIR filter are all integers, configuring the number of the filter multiplexing units according to a largest preset down-sampling multiple among the at least two preset down-sampling multiples; and in a case where the at least two preset down-sampling multiples supported by the FIR filter comprise a fraction, configuring the number of the filter multiplexing units according to a denominator of the preset down-sampling multiple being of a fraction and the preset down-sampling multiple being of an integer in the at least two preset down-sampling multiples.

In an exemplary embodiment, if the FIR filter supports 2 X decimation filtering and 3 X decimation filtering, the FIR filter is required to be configured with three filter multiplexing units. If the FIR filter supports 3/4 X decimation filtering, 2 X decimation filtering and 3 X decimation filtering, the FIR filter is required to be configured with three filter multiplexing units.

In an implementation, operation in S42 includes: configuring the unit maximum order to be greater than or equal to a quotient of the maximum order supported by the FIR filter divided by the number of the filter multiplexing units.

In one exemplary embodiment, the FIR filter is required to support 3/4 X decimation filtering (with a filtering order of 90), 2 X decimation filtering (with a filtering order of 78) and 3 X decimation filtering (with a filtering order of 54). According to the requirement of supporting a maximum order of 90 and a maximum down-sampling multiple of 3, the FIR filter is designed to have total three filter multiplexing units, each of the filter multiplexing units can realize the multi-add operation with a maximum order of 30, and the total three filter multiplexing units can achieve the performance requirements for decimation filtering with a maximum order of 90. Registers are used to control data input to different filter multiplexing units, and configure each of the filter multiplexing units with different filter coefficients, and finally different filtering multiplexing units are combined to achieve the support for different filtering functions. Under the maximum order (each filtering multiplexing unit with a maximum order of 30), a total filtering order of the multi-mode filter may be flexibly defined by software. For the filtering order that does not need to be used, the filter multiplexing unit may be directly configured with filter coefficients of 0. In theory, any filter design with a filtering order unexceeding the maximum order can be supported.

One FIR filter is configured to have multiple filter multiplexing units, and various filtering modes are achieved by different combinations of the filter multiplexing units. The filter down-sampling modes and the filter order can be switched by configuring corresponding registers, which, compared with the way of adopting multiple single-mode filters, reduces the data selection module, the filter parameter configuration register, the number of single-mode filters and corresponding logic circuits. Especially, when dealing with complex scenarios, one multi-mode FIR filter is used to replace existing multiple single-mode filters that are needed to be designed to deal with each complex scenario, and the multi-mode FIR filter can supports more scenarios and reduces resource consumption and the amount of code for logic implementation.

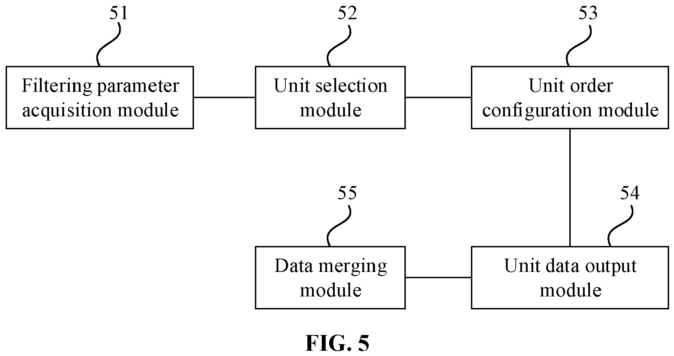

FIG. 5 is a schematic structural diagram of an FIR filter-based filtering apparatus according to an embodiment, and the filtering apparatus can be deployed at a digital receiving front-end, the filtering apparatus includes: a filtering parameter acquisition module 51, a unit selection module 52, a unit order configuration module 53, a unit data output module 54, and a data merging module 55.

The filtering parameter acquisition module 51 is configured to acquire a preset filtering order and a preset down-sampling multiple; the unit selection module 52 is configured to select, according to the preset down-sampling multiple, a corresponding number of filter multiplexing units as used filter multiplexing units, where the FIR filter includes multiple filter multiplexing units; the unit order configuration module 53 is configured to configure, according to the preset filtering order, filtering orders for the used filter multiplexing units; the unit data output module 54 is configured to filter, according to the preset down-sampling multiple, input data allocated to each used filter multiplexing unit through the each used filter multiplexing unit configured with the filtering order, and output unit filtered data; and the data merging module 55 is configured to merge the unit filtered data respectively outputted by the corresponding number of used filter multiplexing units and output merged unit filtered data.

In one embodiment, the unit selection module 52 includes: a first selection sub-module.

The first selection sub-module is configured to select a number of filter multiplexing units same as the preset down-sampling multiple as the used filter multiplexing units in a case where the preset down-sampling multiple is an integer.

Correspondingly, the unit data output module 54 includes: a first unit data calculation sub-module.

The first unit data calculation sub-module is configured to perform multi-add operation on the input data and respective preset filtering coefficients by the each used filter multiplexing unit configured with the filtering order to obtain the unit filtered data, where the multi-add operation is performed in a number of clock cycles same as the preset down-sampling multiple.

In one embodiment, the unit selection module 52 includes: a second selection sub-module.

The second selection sub-module is configured to, in a case where the preset down-sampling multiple is a fraction, selecta number of filter multiplexing units same as a numerator of the preset down-sampling multiple as the used filter multiplexing units.

Correspondingly, the unit filtered data output module 54 includes: a second unit data calculation sub-module.

The second unit data calculation sub-module is configured to perform multi-add operation on the input data and respective preset filtering coefficients by the each used filter multiplexing unit configured with the filtering order to obtain the unit filtered data, wherein the multi-add operation is performed by using a number of clock cycles same as the numerator of the preset down-sampling multiple and within a number of clock cycles same as a denominator of the preset down-sampling multiple

In one embodiment, the filtering apparatus based on an FIR filter further includes: a unit quantity configuration module and a unit order configuration module.

The unit quantity configuration module is configured to, before the preset filtering order and the preset down-sampling multiple are acquired, a number of the plurality of filter multiplexing units in the FIR filter according to at least two preset down-sampling multiples supported by the FIR filter, where each of the at least two preset down-sampling multiples is an integer and/or a fraction. The unit order configuration module is configured to configure a unit maximum order supported by each of the plurality of filter multiplexing units according to a maximum order supported by the FIR filter and the number of the plurality of filter multiplexing units, where the filter multiplexing units are each configured to have functions for performing data beating, timing sequence control, and multi-add operation on data and coefficients.

In one embodiment, the unit quantity configuration module includes: a first quantity configuration sub-module and a second quantity configuration sub-module.

The first quantity configuration sub-module is configured to, in a case where the preset down-sampling multiples supported by the FIR filter are all integers, configure the number of the filter multiplexing units according to a largest preset down-sampling multiple among the at least two preset down-sampling multiples; and the second quantity configuration sub-module is configured to, in a case where the preset down-sampling multiples supported by the FIR filter include a fraction, configure the number of the filter multiplexing units according to a denominator of the preset down-sampling multiple being of a fraction and the preset down-sampling multiple being of an integer in the at least two preset down-sampling multiples.

In one embodiment, the unit order configuration module includes: a unit order configuration sub-module.

The unit order configuration sub-module is configured to configure the unit maximum order to be greater than or equal to a quotient of the maximum order supported by the FIR filter divided by the number of the filter multiplexing units.

For the functions of the multiple modules in the apparatus according to the embodiments of the present application, reference may be made to the corresponding descriptions in the foregoing method embodiments, and details are not described herein again.

A device is provided according to an embodiment of the present application, the device includes a processor and a memory. The processor is configured to execute a program stored in the memory, so as to implement any one of the methods according to the embodiments of the present application.

A storage medium is provided according to an embodiment of the present application, where the storage medium stores a computer program, and the computer program, when being executed by a processor, implements any one of the methods according to the embodiments of the present application.

The term user terminal covers any suitable type of wireless user equipment, such as a mobile telephone, portable data processing device, portable web browser or vehicle mounted mobile station.

In general, the various embodiments of the present application may be implemented in hardware or application specific circuits, software, logic, or any combination thereof. For example, some aspects may be implemented in hardware, while other aspects may be implemented in firmware or software that may be executed by a controller, microprocessor or other computing apparatuses, which is not limited thereto.

Embodiments of the present application may be implemented by the execution of computer program instructions by a data processor of a mobile apparatus, e. g., in a processor entity, or by hardware, or by a combination of software and hardware. Computer program instructions may be assembly instructions, instruction set architecture (ISA) instructions, machine instructions, machine-dependent instructions, microcode, firmware instructions, state setting data, or source code or object code written in any combination of one or more programming languages.

The block diagrams of any logic flow in the figures of the present application may represent program steps, or may represent interconnected logic circuits, modules and functions, or may represent a combination of program steps and logic circuits, modules and functions. Computer programs can be stored on a memory. The memory may be of any type suitable for the local technical environment and may be implemented using any suitable data storage technology, such as, but not limited to, read-only memory (ROM), random access memory (RAM), optical memory apparatuses and systems (digital versatile disc (DVD) or compact disc (CD)), etc. Computerreadable media includes non-transitory storage media. The data processor may be of any type suitable for the local technical environment, such as, but not limited to, a general purpose computer, a special purpose computer, a microprocessor, a digital signal processor (DSP), an application specific integrated circuit (ASIC), a field-programmable logic devices (Field-Programmable Gate Array, FPGA), or processors based on multi-core processor architecture.

## Claims

1. A finite impulse response (FIR) filter-based filtering method, comprising:
acquiring a preset filtering order and a preset down-sampling multiple;
selecting, according to the preset down-sampling multiple, a corresponding number of filter multiplexing units, and using each of the selected filter multiplexing units as a used filter multiplexing unit, wherein the FIR filter comprises a plurality of filter multiplexing units;
configuring, according to the preset filtering order, a filtering order for each used filter multiplexing unit;
filtering, according to the preset down-sampling multiple, input data allocated to each used filter multiplexing unit through the each used filter multiplexing unit configured with the filtering order, to obtain unit filtered data outputted by the each used filter multiplexing unit; and
merging the unit filtered data respectively outputted by the corresponding number of used filter multiplexing units and outputting merged unit filtered data.

2. The method according to claim 1, wherein the selecting, according to the preset down-sampling multiple, a corresponding number of filter multiplexing units comprises:
in a case where the preset down-sampling multiple is an integer, selecting a number of filter multiplexing units same as the preset down-sampling multiple.

3. The method according to claim 2, wherein the filtering, according to the preset down-sampling multiple, input data allocated to each used filter multiplexing unit through the each used filter multiplexing unit configured with the filtering order, to obtain unit filtered data outputted by the each used filter multiplexing unit, comprises:
performing multi-add operation on the input data and respective preset filtering coefficients by the each used filter multiplexing unit configured with the filtering order to obtain the unit filtered data, wherein the multi-add operation is performed in a number of clock cycles same as the preset down-sampling multiple.

4. The method according to claim 1, wherein the selecting, according to the preset down-sampling multiple, a corresponding number of filter multiplexing units comprises:
in a case where the preset down-sampling multiple is a fraction, selecting a number of filter multiplexing units same as a numerator of the preset down-sampling multiple.

5. The method according to claim 4, wherein the filtering, according to the preset down-sampling multiple, input data allocated to each used filter multiplexing unit through the each used filter multiplexing unit configured with the filtering order, to obtain unit filtered data outputted by the each used filter multiplexing unit, comprises:
performing multi-add operation on the input data and respective preset filtering coefficients by the each used filter multiplexing unit configured with the filtering order to obtain the unit filtered data, wherein the multi-add operation is performed by using a number of clock cycles same as the numerator of the preset down-sampling multiple and within a number of clock cycles same as a denominator of the preset down-sampling multiple.

6. The method according to claim 1, wherein before the acquiring a preset filtering order and a preset down-sampling multiple, the method further comprises:
configuring a number of the plurality of filter multiplexing units in the FIR filter according to at least two preset down-sampling multiples supported by the FIR filter, wherein each of the at least two preset down-sampling multiples is at least one of an integer and a fraction; and
configuring a unit maximum order supported by each of the plurality of filter multiplexing units according to a maximum order supported by the FIR filter and the number of the plurality of filter multiplexing units, wherein the filter multiplexing units are each configured to perform data beating, timing sequence control, and multi-add operation on data and coefficients.

7. The method according to claim 6, wherein the configuring a number of the plurality of filter multiplexing units in the FIR filter according to at least two preset down-sampling multiples supported by the FIR filter comprises:
in a case where the at least two preset down-sampling multiples supported by the FIR filter are all integers, configuring the number of the filter multiplexing units according to a largest preset down-sampling multiple among the at least two preset down-sampling multiples; and
in a case where the at least two preset down-sampling multiples supported by the FIR filter comprise a fraction, configuring the number of the filter multiplexing units according to a denominator of the preset down-sampling multiple being of a fraction and the preset down-sampling multiple being of an integer in the at least two preset down-sampling multiples.

8. The method according to claim 6 or 7, wherein the configuring a unit maximum order supported by each of the plurality of filter multiplexing units according to a maximum order supported by the FIR filter and the number of the plurality of filter multiplexing units, comprises:
configuring the unit maximum order to be greater than or equal to a quotient of the maximum order supported by the FIR filter divided by the number of the filter multiplexing units.

9. A finite impulse response (FIR) filter-based filtering apparatus, comprising:
a filtering parameter acquisition module, configured to acquire a preset filtering order and a preset down-sampling multiple;
a unit selection module, configured to select, according to the preset down-sampling multiple, a corresponding number of filter multiplexing units, and use each of the selected filter multiplexing units as a used filter multiplexing unit, wherein the FIR filter comprises a plurality of filter multiplexing units;
a unit order configuration module, configured to configure, according to the preset filtering order, a filtering order for each used filter multiplexing unit;
a unit data output module, configured to filter, according to the preset down-sampling multiple, input data allocated to each used filter multiplexing unit through the each used filter multiplexing unit configured with the filtering order, to obtain unit filtered data outputted by the each used filter multiplexing unit; and
a data merging module, configured to merge the unit filtered data respectively outputted by the corresponding number of used filter multiplexing units and outputting merged unit filtered data.

10. The apparatus according to claim 9, wherein the unit selection module comprises:
a first selection sub-module, configured to select a number of filter multiplexing units same as the preset down-sampling multiple in a case where the preset down-sampling multiple is an integer.

11. The apparatus according to claim 10, wherein the unit data output module comprises:
a first unit data calculation sub-module, configured to perform multi-add operation on the input data and respective preset filtering coefficients by the each used filter multiplexing unit configured with the filtering order to obtain the unit filtered data, wherein the multi-add operation is performed in a number of clock cycles same as the preset down-sampling multiple.

12. The apparatus according to claim 9, wherein the unit selection module comprises:
a second selection sub-module, configured to, in a case where the preset down-sampling multiple is a fraction, select a number of filter multiplexing units same as a numerator of the preset down-sampling multiple.

13. The apparatus according to claim 12, wherein the unit data output module comprises:
a second unit data calculation sub-module, configured to perform multi-add operation on the input data and respective preset filtering coefficients by the each used filter multiplexing unit configured with the filtering order to obtain the unit filtered data, wherein the multi-add operation is performed by using a number of clock cycles same as the numerator of the preset down-sampling multiple and within a number of clock cycles same as a denominator of the preset down-sampling multiple.

14. A device, comprising a processor and a memory;
wherein the processor is configured to execute a program stored in the memory, to implement the finite impulse response (FIR) filter-based filtering method according to any one of claims 1 to 8.

15. A storage medium, storing a computer program, wherein the computer program, when being executed by a processor, implements the finite impulse response (FIR) filter-based filtering method according to any one of claims 1 to 8.
